# EUROPÄISCHE PATENTSCHRIFT

(11) **EP 2 542 841 B1**
(45) Veröffentlichungstag und Bekanntmachung des Hinweises auf die Patenterteilung: **26.06.2013**
(21) Anmeldenummer: 11708674.4
(22) Anmeldetag: 02.03.2011
(51) Int. Cl.: F24J 2/12, F24J 2/14, F24J 2/52

(54) **KISSENFÖRMIGER KONZENTRATOR**
CUSHION-SHAPED CONCENTRATOR
CONCENTRATEUR EN FORME DE COUSSIN

(30) Priorität: 05.03.2010 AT 3552010
(43) Veröffentlichungstag der Anmeldung: 09.01.2013
(73) Patentinhaber: Heliovis AG, 2351 Wiener Neudorf (AT)
(72) Erfinder: TIEFENBACHER, Felix, A-2340 Mödling (AT); HÖFLER, Johannes, CH-4127 Birsfelden (CH)
(74) Vertreter: Sonn & Partner Patentanwälte
(86) Internationale Anmeldenummer: PCT/AT2011/000101
(87) Internationale Veröffentlichungsnummer: WO 2011/106811

(56) Entgegenhaltungen:
- WO-A1-2010/017594
- WO-A2-2008/037108
- WO-A2-2009/117840
- US-A1- 2009 223 508
- US-A1- 2009 260 620

## Beschreibung

Die Erfindung betrifft einen kissenförmigen Konzentrator zur Bündelung elektromagnetischer Strahlung, insbesondere Sonnenstrahlung, in einem Absorber, mit einer im Betrieb der einfallenden Strahlung zugewandten transparenten Membran und einer Reflektormembran, die die auftreffende Strahlung in Richtung des Absorbers reflektiert.

Ein solcher Konzentrator ist aus der WO 2010/017594 A1 bekannt.

Aus der AT 505 075 B1 ist ein aufblasbarer Sonnenkollektor bekannt, der aus zumindest zwei Kammern aufgebaut ist, die durch eine einseitig verspiegelte Reflektormembran separiert und unabhängig voneinander mit einem Gas beaufschlagbar sind. Oberhalb der Reflektormembran ist ein langgestreckter Absorber im Bereich der Mantelfläche der schlauchförmigen Hülle angeordnet. Die zur Reflexion der auftreffenden Sonnenstrahlung im Absorber erforderliche Wölbung der Reflektormembran wird dadurch erzielt, dass die beiden Kammern jeweils mit einem unterschiedlichen Druck beaufschlagt werden. Dieser Sonnenkollektor funktioniert grundsätzlich einwandfrei und eignet sich beispielsweise für kleinere terrestrische Solaranlagen.

Die US 2004/027310 A1 beschreibt eine kugelförmige Hülle zur Konzentration von Sonnenstrahlung. Die kugelförmige Hülle ist durch einen Spiegel in zwei im Wesentlichen halbkugelförmige Kammern unterteilt, zwischen denen ein Druckunterschied aufrecht erhalten wird.

Demnach sind bei diesem Stand der Technik zumindest eine äußere Hülle und eine im Inneren der Hülle angeordnete Reflektormembran bzw. ein Spiegel erforderlich, was eine aufwendige Herstellung bedingt. Zudem bedingt diese Anordnung eine schlechte Flächennutzung, da die Abstände zwischen den Konzentratoren zur Minimierung gegenseitiger morgendlicher und abendlicher Verschattung in beträchtlichem Abstand zueinander aufgestellt werden müssen.

Aus der DE 10 2008 020 851 A1 ist einerseits ein aufblasbares Kissen bekannt, das im aufgeblasenen Zustand eine paraboloide Gestalt einnimmt. Die einfallende Sonnenstrahlung wird von einer Reflektormembran über einen Einkoppelspiegel in ein lichtleitendes Halterohr eingekoppelt, der die Strahlungsenergie über einen Lichtleiter zu einem Absorber führt. Demnach ist hier der Absorber außerhalb des Kissens angebracht. Zudem wird ein Folien-Parabolrinnen-Modul beschrieben, das als "Rondell" ausgebildet ist und eine Deckenkonstruktion besitzt. Diese Deckenkonstruktion weist eine Decke auf, an der eine Parabolrinnen-Anordnung mit einer Spiegelfolie aufgehängt ist, welche die einfallende Sonnenstrahlung auf Absorber-Röhren konzentriert. Zudem ist ein Gestänge vorgesehen, welches zur Stabilisierung der transparenten Decke dient. Die Aufhängung der Folie ist jedoch von der Schwerkraft abhängig, so dass sich eine Lageänderung auf die Gestalt der Folie auswirken würde; demnach ist diese Ausführung für eine flexibel umstellbare Anordnung nicht geeignet.

Aus der EP 0 050 697 A1 ist ein Konzentrator in Form eines aerodynamischen Tragflügels bekannt, welcher eine transparente Folie und einen von einer Haut umgebenen Stützkörper aufweist. Die Oberseite des Stützkörpers ist mit einer reflektierenden Folie bedeckt, welche mit der transparenten Folie ein Kissen bildet, das mit Gas unter Überdruck befüllt ist, so dass die Folie konvex gekrümmt ist. Die einfallende Strahlung wird in einem - außerhalb des Kissens angeordneten - Absorbersystem gebündelt. Zudem ist ein Netzwerk vorgesehen, das einen Teil der Kräfte auf den Stützkörper überträgt, so dass die Folie dünn ausgebildet werden kann. Der quasi homogene Stützkörper, der aus Hartschaum oder ähnlichem Material fertigbar ist, kann durch ein Stützgerüst aus Holmen und Rippen ersetzt werden kann. Somit ist hier ein aufwendiger, außerhalb des Kissens angebrachter Stützkörper oder ein entsprechendes Stützgerüst erforderlich, um die gewünschte Form des Konzentrators zu erreichen.

In der US 5,990,851) ist eine andersartige, für den Weltraumeinsatz gedachte Antennenstruktur beschrieben, mit einer Reflektorfläche, welche durch eine Tragstruktur in Form eines kreisringförmigen Schlauchs gestützt ist. Die Antennenstruktur weist weiters eine Spannstruktur auf, welche durch ein zusammenklappbares Netzwerk aus vertikalen, quer verlaufenden oder in Umfangsrichtung verlaufenden Verbindungselementen (Gurte, Bänder etc.) gebildet ist. Die Reflektorfolie ist an vertikalen Verbindungselementen derart befestigt, dass eine fokussierende (Parabol-)fläche ausgebildet ist.

Aus der GB 1 602 434 ist ein Sonnenkollektor mit einem Reflektor und einem transparenten Abdeckteil bekannt. Zur Stabilisierung der Anordnung ist eine außen angebrachte Fachwerkstruktur vorgesehen, welche einen Arm mit einem daran befestigten Absorber trägt.

In der DE 20 2007 000 702 U1 ist ein Nachführungssystem für eine Photovoltaikanlage, die auf einer schwimmenden Insel gelagert ist, beschrieben.

Aus der DE 100 58 065 A1 ist ein aufblasbaren Reflektor, beispielsweise für eine Parabol-Antenne, bekannt, der mehrere aufblasbare Kammern aufweist, die an einer gemeinsamen Tragwand angeordnet sind, welche mit einer elektromagnetisch und/oder optisch reflektierenden Schicht beschichtet ist. Die Tragwand kann mit einem Befestigungsnetz aus Seilen oder dergl. befestigt sein.

Demgegenüber besteht die Aufgabe der vorliegenden Erfindung darin, einen konstruktiv einfachen, kostengünstigen kissenförmigen Konzentrator der eingangs angeführten Art zu schaffen, mit welchem elektromagnetische Strahlung, insbesondere Sonnenstrahlung, mit hoher Effizienz in einem Absorber konzentriert werden kann.

Dies wird bei dem kissenförmigen Konzentrator der eingangs angeführten Art dadurch erzielt, dass die transparente Membran und die Reflektormembran eine äußere Hülle für einen mit einem Gas unter Überdruck befüllten Raum bilden, wobei zwischen der transparenten Membran und der Reflektormembran Spannelemente angeordnet sind, die Einschnürungen an der Reflektormembran erzeugen, die konkav gewölbte Abschnitte der Reflektormembran trennen.

Beim erfindungsgemäßen Konzentrator ist die Reflektormembran Teil der äußeren Hülle, die in ihrem Inneren den mit Gas befüllten Raum einschließt. Die elektromagnetische Strahlung tritt durch die in Richtung der Strahlungsquelle ausgerichtete transparente Membran, wird an der Reflektormembran (beispielsweise einer verspiegelten Membran) reflektiert und im Absorber konzentriert und dort energetisch umgesetzt. Als Absorber können mediendurchströmte Röhren, Photovoltaikelemente etc. dienen.

Aufgrund des Druckgefälles zwischen dem druckbeaufschlagten Raum und der Außenseite wirkt auf die transparente Membran bzw. die gegenüberliegende Reflektormembran eine nach außen gerichtete Kraft. Die Spannelemente wirken in ihrem gespannten Zustand dem vorherrschenden Überdruck entgegen. Auf diese Weise kann mit den Spannelementen die gewünschte Geometrie des kissenförmigen Konzentrators gezielt eingestellt werden. Die transparente Membran und die Reflektormembran bilden gemeinsam eine äußere Hülle des Konzentrators, so dass eine gesonderte Anordnung der Reflektormembran im Inneren der Hülle nicht erforderlich ist. Demnach wird eine besonders material- und somit kostensparende Ausführung erzielt. Da die Reflektormembran und die transparente Membran mittelbar bzw. unmittelbar über die im Inneren des eingeschlossenen Raums angeordneten Spannelemente miteinander verspannt sind, kann eine stabile Anordnung insbesondere auch bei einer großflächigen Ausführung des Konzentrator-Kissens erzielt werden.

Im Hinblick auf eine effiziente Bündelung der einfallenden Strahlung im Absorber erzeugen die Spannelemente Einschnürungen an der Reflektormembran, die konkav gewölbte Abschnitte der Reflektormembran trennen. Das druckbeaufschlagte Gas im Inneren des Konzentrators bewirkt, dass die Reflektormembran bzw. die transparente Membran zwischen den Angriffspunkten der Spannelemente an der jeweiligen Membran von den einfallenden Strahlen aus gesehen konkav bzw. nach innen gewölbt ist. Über die Anordnung der durch die Angriffsstellen der Spannelemente gebildeten Einschnürungen der Reflektormembran können gewölbte Abschnitte der Reflektormembran erzeugt werden, die in Abhängigkeit von der Geometrie des Absorbers eine zweckmäßige und wirkungsvolle Bündelung der einfallenden Strahlung erlauben.

Im Hinblick auf eine materialsparende, kostengünstige Ausführung ist es von Vorteil, wenn als Spannelement ein Längselement, insbesondere ein quer zu seiner Längserstreckungsrichtung formveränderliches Längselement, vorzugsweise ein Seil oder ein starres Längselement, vorzugsweise eine Stange, vorgesehen ist, das unter Zugbeanspruchung gespannt ist. Demnach ist das Spannelement ab einem gewissen Mindestdruck im eingeschlossenen Raum des Konzentrators unter Zug gespannt. Das Längselement ist an im Wesentlichen punktförmigen bzw. kleinflächigen Angriffsstellen an der transparenten Membran bzw. der Reflektormembran befestigt, so dass im Wesentlichen punktförmige bzw. kleinflächige Einschnürungen ausgebildet werden. Wenn als Längselement ein formveränderliches Seil oder dgl. verwendet wird, kann eine besonders platzsparende Anordnung des Konzentrators erzielt werden, bevor dieser in Betrieb genommen wird. Andererseits können starre Längselemente, wie Stangen oder dgl. eingesetzt werden, die unabhängig vom Gasdruck eine Verspannung der Hülle ermöglichen.

Insbesondere bei einer großflächigen Ausführung des kissenförmigen Konzentrators ist es günstig, wenn die transparente Membran bzw. die Reflektormembran auf zumindest einem starren Längsträger abgestützt ist. Der Längsträger verläuft in einer im Wesentlichen parallel zur Haupterstreckungsebene des Konzentrators angeordneten Ebene. Vorzugsweise ist jeweils eine Mehrzahl von starren, insbesondere parallel zueinander angeordneten Längsträgern mit der transparenten Membran bzw. der Reflektormembran verbunden.

Bei einer bevorzugten Ausführungsform ist vorgesehen, dass jeweils zwei oder mehr Spannelemente an einem gemeinsamen Befestigungsbereich insbesondere des starren Längsträgers befestigt sind. Demnach greifen die Endbereiche von jeweils zwei Spannelementen in demselben Befestigungsbereich an.

Eine Unterteilung der Hülle in vorzugsweise idente Abschnitte kann erzielt werden, wenn die Spannelemente in eine Längsrichtung der Hülle fachwerkartig abgewinkelt angeordnet sind. Eine derartige "Zick-Zack-Verspannung", wie sie in einem anderen Zusammenhang aus der Architektur bekannt ist, ermöglicht eine optimale Raumnutzung sowie eine besonders stabile, gleichmäßige Verspannung der Hülle bei gleichzeitig geringer Verschattung der Spiegelfläche. Andere besonders vorteilhafte Formen der Reflektormembran, wie jene paralleler Rinnen und schachbrettmusterförmig oder wabenförmig angeordnete Schüsseln, lassen sich durch entsprechende Wahl der Befestigungsbereiche für die Spannelemente, insbesondere in Verbindung mit gegen Durchbiegung starren bzw. flexiblen Längsträgern, erreichen.

Um den kissenförmigen Konzentrator gezielt an veränderliche Bedingungen, beispielsweise an den zeitlichen Verlauf des Sonnenstands, anpassen zu können, ist es günstig, wenn die Hülle zur Erzielung einer einachsigen Nachführung um eine senkrecht zu ihrer Haupterstreckungsebene verlaufende Drehachse drehbar gelagert ist. Die drehbare Anordnung des Konzentrators kann bei einer terrestrischen Anwendung beispielsweise durch Auflagerrollen erfolgen.

Vielfach ist es zudem günstig, wenn die Hülle insbesondere durch lokale Veränderung einer auf die Hülle wirkenden Auftriebskraft um eine in der Haupterstreckungsebene der Hülle verlaufende Drehachse drehbar gelagert ist. Demnach kann die Hülle gekippt werden, was im Fall einer Ausführung des Konzentrators als Sonnenkollektor eine Nachführung an den Sonnenstand um eine weitere Achse ermöglicht. Die auf die Hülle wirkende Auftriebskraft kann auf vielfältige Weise beeinflusst werden. Beispielsweise kann zwischen getrennten, insbesondere asymmetrisch angeordneten Kammern des Konzentrators ein Druckgefälle aufgebaut werden.

Eine zweckmäßige Verspannung des eingeschlossenen Raums des Konzentrators kann erzielt werden, wenn die Spannelemente insbesondere sternförmig zwischen einem zentral im Inneren der Hülle angeordneten Befestigungskörper und der transparenten Membran bzw. der Reflektormembran gespannt sind. Der Befestigungskörper ist vorzugsweise mittig zwischen der transparenten Membran und der Reflektormembran angeordnet und wird durch in entgegengesetzte Richtungen wirkende Spannelemente, insbesondere gespannte Seile, an seinem Platz gehalten. Eine besonders günstige Position ist jeder Punkt auf einer Mittellinie zwischen der Verbindungslinie aller Reflektormembran-Kugelmittelpunkte bzw. der Refelktormembran-Zylinderachse Mittelachse einerseits und der Verbindungslinie aller tiefsten Punkte der Reflektormembran andererseits.

Um den Strahlquerschnitt der von der Reflektormembran reflektierten Strahlung gezielt beeinflussen zu können, ist es von Vorteil, wenn ein konkav gewölbter Abschnitt der Reflektormembran durch ein Schnittmuster der Reflektormembran bzw. durch den Überdruck des Gases im Inneren der Hülle derart geformt ist, dass die von der Reflektormembran reflektierte Strahlung in einer im Wesentlichen linienförmigen oder einer im Wesentlichen punktförmigen Fläche am Absorber gebündelt wird. Unter den Begriff "Schnittmuster" fällt hierbei eine geeignete Formgebung der Reflektormembran, beispielsweise die Zusammensetzung aus Segmenten, wie es bei Fuß- oder Wasserbällen bekannt ist. Demnach kann die konkave Wölbung der Reflektormembran in einem bestimmten Abschnitt einerseits durch Auswahl eines geeigneten Schnittmusters eingestellt werden, insbesondere kann auch eine lokal unterschiedliche Durchbiegbarkeit der Reflektormembran vorgesehen sein. Andererseits kann durch Erhöhung bzw. Erniedrigung des Gasdrucks der Krümmungsradius des gekrümmten Abschnitts erhöht bzw. erniedrigt werden. Das ist bei einem prall gefüllten Körper aus unelastischen Membranen nicht der Fall.

Beispielsweise kann durch unterschiedliche Materialstärken der Reflektormembran oder die Integration bestimmter formgebender Elemente an dafür vorgesehenen Stellen zu einer gewünschten Form der Reflektormembran führen. Die Dimensionen des kissenförmigen Konzentrators können von wenigen Metern bis hin zu mehreren Kilometern reichen.

Bei einer bevorzugten, kostengünstigen Ausführung ist vorgesehen, dass als Absorber zumindest ein langgestreckter Linienabsorber vorgesehen ist, dem jeweils ein konkav gewölbter Abschnitt der Reflektormembran mit einer in Längserstreckungsrichtung des Linienabsorbers im Wesentlichen konstanten Wölbung zugeordnet ist. Demnach wird bei dieser Ausführung die von der Reflektormembran reflektierte Strahlung in einer langgestreckten bzw. im Wesentlichen linienförmigen Fläche gebündelt, die möglichst genau durch den Linienabsorber abgedeckt wird. Dem Linienabsorber ist ein im Wesentlichen zylindrisch gekrümmter Abschnitt der Reflektormembran zugewandt, mit dem die eintreffende Strahlung entlang der Längserstreckung des Linienabsorbers gebündelt wird.

Zur Befestigung des Linienabsorbers im Inneren der Hülle ist es von Vorteil, wenn der Linienabsorber an einem mit der transparenten Membran verbundenen Längsträger befestigt ist. Der Linienabsorber ist dabei parallel zur Haupterstreckungsebene des Konzentrators ausgerichtet und vorzugsweise benachbart der transparenten Membran angeordnet.

Zur Erhöhung der Strahlungsausbeute bzw. des erzielbaren Konzentrationsfaktors ist es von Vorteil, wenn als Absorber in Abstand zueinander angeordnete kleinflächige Punktabsorber vorgesehen sind, wobei jedem Punktabsorber ein in der Art eines Rotationskörpers, insbesondere einer Kugelkalotte oder eines Paraboloids, konkav gewölbter Abschnitt der Reflektormembran zugeordnet ist. Demnach wird eine langgestreckte Absorberfläche, wie sie mit einem Linienabsorber ausgenutzt wird, in mehrere, vorzugsweise in konstantem Abstand zueinander angeordnete, Punktabsorber aufgelöst. Zur Erzielung einer punktförmigen Fokussierung des reflektierten Strahls sind die entsprechenden Abschnitte der Reflektormembran jeweils in der Art eines Rotationskörpers gekrümmt.

Wie vorstehend beschrieben, kann eine zumindest einachsige Nachführung des kissenförmigen Konzentrators durch Verschwenkung der Hülle um eine senkrecht bzw. parallel zur Haupterstreckungsebene des Konzentrators verlaufende Achse erfolgen. Vielfach ist es jedoch günstig, wenn der bzw. die Absorber mit einer Antriebsvorrichtung, insbesondere einem selbsthemmenden Untersetzungsgetriebe, einem Schrittmotor, oder einem hydraulisch oder pneumatisch betätigbaren Linearantrieb, verschieblich bzw. um zumindest eine Drehachse verschwenkbar gelagert ist bzw. sind. Demnach kann der bzw. können die Absorber zusätzlich oder alternativ zur Nachführung des Konzentrators durch Kippen bzw. Drehen der Hülle mit der Antriebsvorrichtung laufend einem dann in zumindest einer Achse relativ zur Konzentratorfläche beweglichen Fokus nachgeführt, d.h. gezielt verschoben bzw. verschwenkt werden.

Bei einer bevorzugten Ausführungsform ist vorgesehen, dass der Absorber mit der Antriebsvorrichtung einachsig entlang einer insbesondere kreisbogenförmig gekrümmten Bahn oder zweiachsig entsprechend insbesondere einer Rotationskörperoberfläche verschiebbar bzw. verschwenkbar ist. In vielen Fällen, insbesondere bei einem Sonnenkollektor, ist es erforderlich, dass die Orientierung des Absorbers in zwei Achsen veränderbar ist. Dies kann durch einen zweiachsig verschiebbaren bzw. verschwenkbaren Absorber erfolgen. Wenn der Absorber einachsig in einer im Wesentlichen eindimensionalen Bahn verschieb- bzw. verschwenkbar ist, kann die Nachführung um die zweite Achse durch Verschwenkung bzw. durch Kippen des kissenförmigen Konzentrators erfolgen. Bei der einachsigen Nachführung wird der Absorber - entsprechend der Geometrie des dem Absorber zugewandten gewölbten Abschnitts der Reflektormembran - auf einer im Wesentlichen kreisbogenförmig gekrümmten Bahn geführt. Bei der zweiachsigen Nachführung ist der Absorber in einer Fläche, insbesondere einer Rotationskörperoberfläche, verschieb- bzw. verschwenkbar. Die Bahn eines Punktabsorbers verläuft dabei insbesondere auf der Oberfläche einer Kugel- bzw. Paraboloidoberfläche.

Zur verschiebbaren bzw. verschwenkbaren Lagerung des Absorbers ist es günstig, wenn der Absorber über ein Verbindungselement, insbesondere eine verschwenkbare Verbindungsstange, an zumindest einem ortsfesten Befestigungskörper gelagert ist. Als ortsfester Befestigungskörper ist dabei vorzugsweise der mittig zwischen der transparenten Membran und der Reflektormembran angeordnete Befestigungskörper vorgesehen, von dem die Spannelemente insbesondere sternförmig zur transparenten Membran bzw. Reflektormembran gespannt sind. Demnach kann der zentrale Befestigungskörper sowohl als zentraler Angriffspunkt für die Spannelemente als auch als Aufhängung für den Absorber dienen. Wenn die Verbindungsstange gegenüber dem Befestigungskörper verschwenkt wird, beschreibt der mit dem freien Ende der Verbindungsstange verbundene Absorber eine im Wesentlichen kreisbogenförmige Bahn.

Zur präzisen Auflösung des einfallenden Strahlenbündels in die im Wesentlichen punktförmigen Punktabsorber ist es von Vorteil, wenn die Punktabsorber über eine gemeinsame Kupplung, insbesondere eine Kupplungsstange oder ein Seil, in ihrer Relativposition unbeweglich zueinander angeordnet sind, wobei die Punktabsorber mit der Antriebsvorrichtung synchron verschieblich bzw. verschwenkbar sind. Demnach kann die Stellung der Punktabsorber gekoppelt zueinander in eine bzw. in zwei Achsen verändert werden, wobei zur Steuerung der Nachführung vorzugsweise eine mit der Antriebsvorrichtung in Verbindung stehende Steuereinrichtung vorgesehen ist. Die relative Stellung der Punktabsorber zueinander ist dabei unabhängig von der jeweiligen Auslenkung des Verbindungselements, wobei jeder Punktabsorber für sich genommen um seine Drehachse, die insbesondere durch das am Befestigungskörper befestigte Ende der Kupplungsstange gebildet ist, verschwenkbar ist.

Um die Funktion des kissenförmigen Konzentrators auch dann zumindest teilweise aufrecht zu erhalten, wenn die Hülle eine undichte Stelle aufweist, ist es von Vorteil, wenn die Hülle durch zumindest eine insbesondere transparente Folie in zumindest zwei Kammern unterteilt ist, wobei diese Folie vorzugsweise als Spannelement ausgebildet ist. Demnach bewirkt ein punktförmiges Leck in der Hülle lediglich den Ausfall der betroffenen Kammer, wobei die übrigen Kammern davon unbeeinflusst ihre Funktion wahrnehmen können. Mit der Folie soll demnach eine luftdichte Unterteilung des von der Hülle eingeschlossenen Raumes vorgenommen werden. Zudem kann die Folie im Betrieb gespannt sein, um als Spannelement die seilartigen Spannelemente zu unterstützen bzw. zu ersetzen.

Eine vorteilhafte Unterteilung des gasbefüllten Raums kann erzielt werden, wenn die Hülle durch im Wesentlichen parallel zueinander angeordnete Folien in langgestreckte Kammern unterteilt ist. Demnach ist der Raum durch die parallel angeordneten Folien in eine Mehrzahl von langgestreckten Kammern unterteilt.

Dabei ist es insbesondere günstig, wenn die langgestreckten Kammern jeweils durch quer zu ihrer Längserstreckung verlaufende Folien unterteilt sind. Somit ergibt sich eine im Wesentlichen schachbrettartige Anordnung der einzelnen Kammern im Konzentrator. Bei einer alternativen Ausführung ist eine wabenförmige Unterteilung des eingeschlossenen Raums vorgesehen.

Eine bevorzugte Ausführung der Erfindung sieht ein Solarkraftwerk mit dem erfindungsgemäßen Konzentrator vor, das an Land zur Gewinnung von nützbarer Energie aus der Sonnenstrahlung eingesetzt wird.

Hinsichtlich einer von der vorherrschenden Wetterlage unabhängigen Ausnützung der Sonnenenergie ist es günstig, wenn der Konzentrator über den Wolken in der Stratosphäre positioniert wird. Zu diesem Zweck kann der Raum im Inneren der Hülle mit einem Auftriebsgas (beispielsweise einem Edelgas) befüllt sein. Das Kissen kann dabei einerseits freischwebend in der Art eines Zeppelins ausgebildet sein.

Bei einer bevorzugten Ausführungsform ist jedoch vorgesehen, dass die mit dem Auftriebsgas befüllte Hülle über zumindest ein Befestigungselement, vorzugsweise ein Seil, an einer Bodenfläche verankerbar ist.

Zur Ausrichtung des schwebenden Kissens an der Strahlungsquelle ist es günstig, wenn die mit dem Auftriebsgas befüllte Hülle über an unterschiedlichen Stellen am Kissen angreifende Befestigungselemente um zumindest eine in der Haupterstreckungsebene der Hülle verlaufende Drehachse drehbar gelagert ist.

Um den kissenförmigen Konzentrator zu kippen bzw. zu verschwenken, ist es günstig, wenn das Kissen zumindest zwei unabhängig voneinander mit dem Auftriebsgas befüllbare Kammern aufweist. Demnach kann in den Kammern eine Druckdifferenz eingestellt werden, die eine unterschiedliche Auftriebskraft auf die Kammern und somit eine Verschwenkung des Konzentrators bewirkt. Günstig ist es weiters, wenn an der Rückseite oder am Rand des kissenförmigen Konzentrators zumindest eine Ballastkammer vorgesehen wird, durch deren variable Befüllung mit einer Flüssigkeit der Schwerpunkt verlagert und damit die Ausrichtung gezielt beeinflusst werden kann.

Neben einer terrestrischen Nutzung insbsondere als Solarkraftwerk und einer Ausführung als mit einem Auftriebsgas befülltes schwebendes Kissen kann der vorstehend beschriebene kissenförmige Konzentrator in einer schwimmenden Plattform zum Einsatz kommen. Die schwimmende Plattform weist ein flächiges Deckelement und ein mit dem Deckelement verbundenes Abdichtelement auf, das im Betrieb in dichtendem Kontakt mit einer Flüssigkeitsoberfläche steht und gemeinsam mit dem Deckelement und der Flüssigkeitsoberfläche bzw. einer Bodenfläche einen geschlossenen Hohlraum einschließt, in dem mit einer Drucklufterzeugungsvorrichtung ein die Plattform tragender Überdruck herstellbar ist.

Zur gezielten Beeinflussung der auf die schwimmende Plattform einwirkenden Auftriebskräfte ist es von Vorteil, wenn das Deckelement bzw. das Abdichtelement mit einem Schwimmkörper, insbesondere einem langgestreckten Schwimmkörper, der im Betrieb tief in die Flüssigkeit ragt, einem im Betrieb auf der Flüssigkeitsoberfläche treibenden Schwimmkörper, oder einem vollständig in die Flüssigkeit eingetauchten Schwimmkörper, verbunden ist, wobei vorzugsweise eine Mehrzahl von Schwimmkörpern untereinander insbesondere mittels Verstrebungen oder Verspannungen verbunden sind. Die langgestreckten Schwimmkörper mit geringem Querschnitt eignen sich insbesondere für Gewässer mit hohem Seegang, da sie der Wellenbewegung nur geringen Widerstand entgegensetzen. Dabei ist es insbesondere günstig, wenn diese langgestreckten Schwimmkörper in der Art von Rohrbojen in eine Tiefe ragen, in der die Wellenenergie gegenüber der Wasseroberfläche erheblich abgenommen hat. Die an der Flüssigkeitsoberfläche aufgesetzten Schwimmkörper eignen sich insbesondere für ruhige Gewässer und können in der Art von herkömmlichen kompakten Bojen ausgeführt sein. Zur gleichmäßigen Verteilung der eingeleiteten Wellenenergie können die Schwimmkörper untereinander verspannt bzw. verseilt sein.

Bei einer bevorzugten Ausführung der schwimmenden Plattform ist vorgesehen, dass insbesondere im Bereich einer senkrecht zu ihrer Haupterstreckungsebene verlaufenden Drehachse Komponenten für einen Betrieb der Plattform als Solaranlage, insbesondere ein Wechselrichter bzw. eine Dampfturbine, vorgesehen sind. Demnach kann die Plattform als schwimmendes Solarkraftwerk eingesetzt werden, das auf einem natürlichen oder einem künstlich angelegten Gewässer bzw. einer Beckenanlage treibt.

Die vorliegende Erfindung wird anhand der beigefügten Zeichnungen, welche Ausführungsbeispiele und Anwendungsmöglichkeiten zeigen, näher erläutert.

Darin zeigen
Fig. 1a-1d verschiedene Ausführungsformen kissenförmiger Konzentratoren im Querschnitt;
Fig. 2 einen runden kissenförmigen Konzentrator in teilweise geschnittener perspektivischer Ansicht;
Fig. 3a und 3b eine weitere Ausführungsform eines kissenförmigen Konzentrators mit beweglich angeordneten Absorbern;
Fig. 4 eine weitere Ausführungsform eines kissenförmigen Konzentrators;
Fig. 5 eine perspektivische Ansicht einer schwimmenden Plattform mit einem erfindungsgemäßen kissenförmigen Konzentrator zur Verwendung als Solarkraftwerk; und
Fig. 6 eine weitere Ausführungsform eines ortsfesten kissenförmigen Konzentrators mit eindimensional gekrümmter Reflektormembran im Querschnitt.

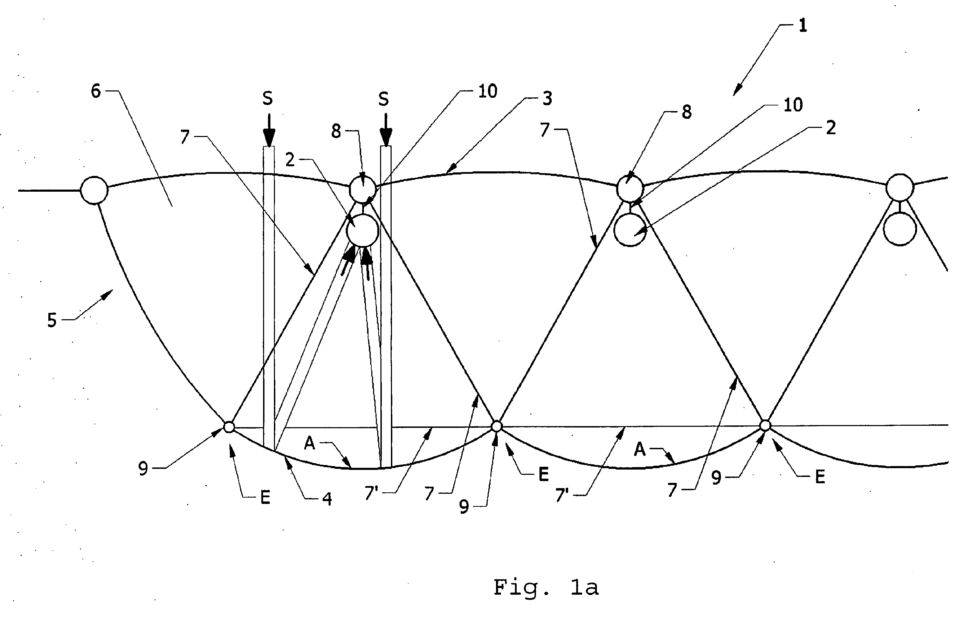

In den Fig. 1a bis 1d ist jeweils ein Teil eines kissenförmigen Konzentrators 1 zur Bündelung elektromagnetischer Strahlung, insbesondere Sonnenstrahlung, in geschnittener Form schematisch dargestellt. Der Konzentrator 1 dient insbesondere zur Bündelung von Sonnenstrahlen S in einem Absorber 2. Im Absorber 2 werden die gebündelten Sonnenstrahlen S entsprechend energetisch umgesetzt. Als Absorber 2 können mediendurchströmte Röhren, Photovoltaikelemente oder dgl. verwendet werden. Die Sonnenstrahlen S durchtreten eine transparente Membran 3 und treffen auf eine Reflektormembran 4 auf, von welcher sie in Richtung des Absorbers 2 reflektiert werden. Die transparente Membran 3 und Reflektormembran 4 sind aus geeignetem, vorzugsweise beständigem, Kunststoffmaterial sowie -beschichtung gebildet. Die transparente Membran 3 und Reflektormembran 4 bilden eine äußere Hülle 5 für einen mit einem Gas unter Überdruck befüllten Raum 6. Als Gas kann Luft oder ein Auftriebsgas, welches dem kissenförmigen Konzentrator 1 für Anwendungen in der Luft einen entsprechenden Auftrieb verleiht, beispielsweise ein Edelgas, verwendet werden.

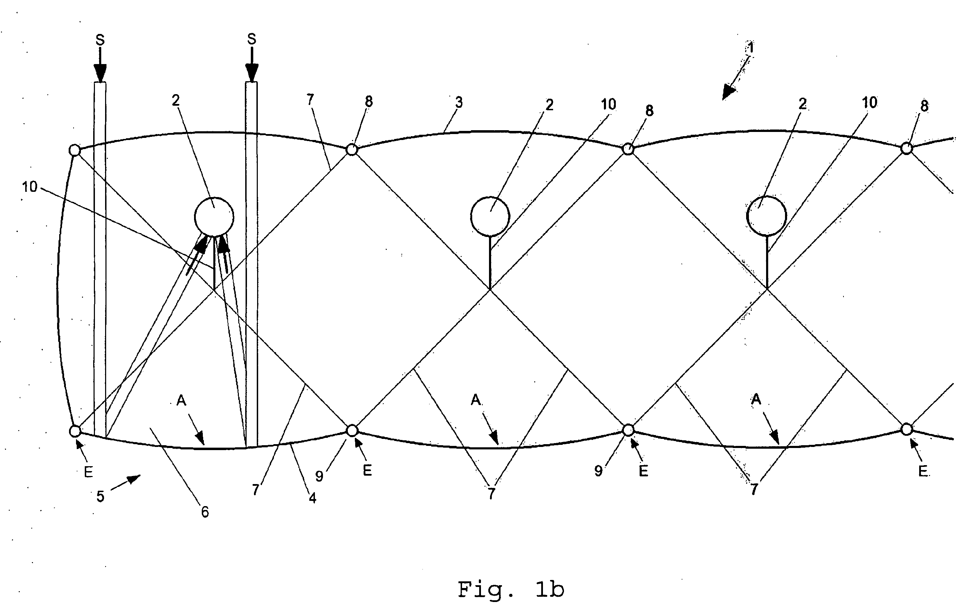

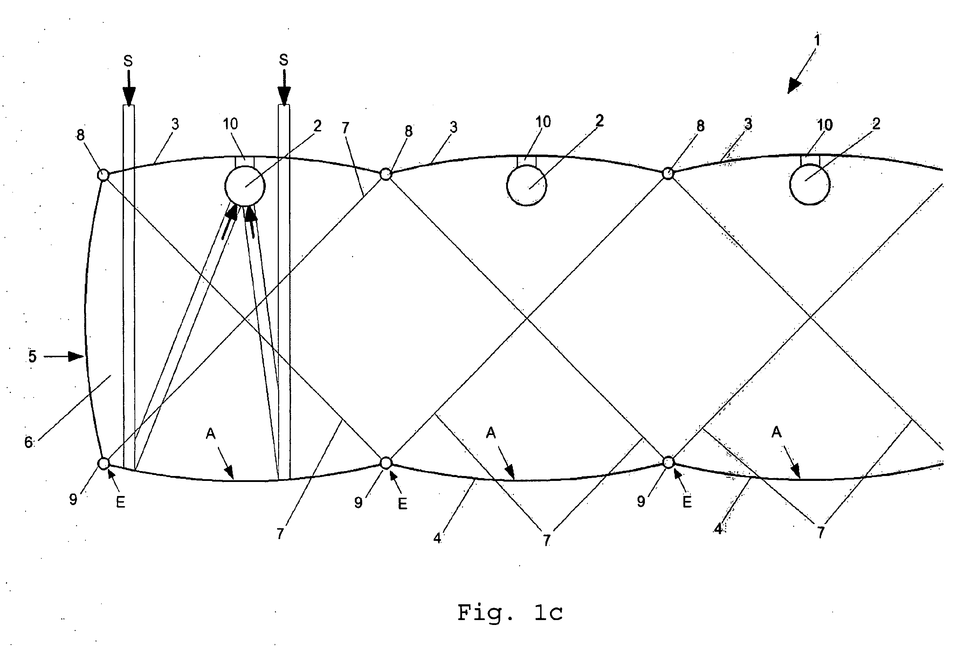

Auch ist es möglich, dass zumindest teilweise im Raum 6 eine beispielsweise transparente Flüssigkeit angeordnet wird. Zwischen der transparenten Membran 3 und der Reflektormembran 4 sind Spannelemente 7 angeordnet, welche dem Überdruck im Raum 6 entgegenwirken, wodurch an den Befestigungsstellen der Spannelemente 7 an der transparenten Membran 3 und der Reflektormembran 4 Verformungen derselben gebildet werden. Dadurch kann eine gewünschte Formgebung, insbesondere der Reflektormembran 4 in Bezug auf die zu bündelnde Strahlung, insbesondere die Sonnenstrahlung S, bewirkt werden und die Konzentration im Absorber 2 optimiert werden. Die Verbindung zwischen der transparenten Membran 3 und der Reflektormembran 4 zur Bildung der äußeren Hülle 5 kann durch die transparente Membran 3 selbst, die Reflektormembran 4 oder eine eigens angeordnete Membran oder dgl. gebildet werden. Als Spannelemente 7 kommen beispielsweise Seile oder Stangen aus geeignetem Material in Frage. Bei der Verwendung von Seilen als Spannelemente 7 kann der kissenförmige Konzentrator 1 besonders platzsparend transportiert werden, da die transparente Membran 3 und die Reflektormembran 4 aufeinander gelegt werden können. Von Vorteil ist es, wenn die transparente Membran 3 und bzw. oder die Reflektormembran 4 auf entsprechenden starren Längsträgern 8, 9 abgestützt ist. Dies verleiht der Konstruktion eine entsprechende Stabilität und ermöglicht die geeignete Befestigung der Spannelemente 7. Die Spannelemente 7 erzeugen an der Reflektormembran 4 entsprechende Einschnürungen E und somit konkav gewölbte Abschnitte A in der Reflektormembran 4, in welchen die elektromagnetische Strahlung, insbesondere Sonnenstrahlung S, optimal in Richtung der Absorber 2 reflektiert werden. Bei der Ausführungsform gemäß Fig. 1a sind die Spannelemente 7 zwischen der transparenten Membran 3 und der Reflektormembran 4 in Zick-Zack-Form angeordnet. Bei den Varianten gemäß den Fig. 1b und 1c sind die Spannelemente 7 kreuzförmig zwischen der transparenten Membran 3 und der Reflektormembran 4 angeordnet.

Zusätzlich können weitere Spannelemente 7' zwischen den Längsträgern 9 angeordnet werden, um die Krümmung der Reflektormembran 4 einzustellen. Das unter Überdruck stehende Gasvolumen innerhalb des Raumes 6 der äußeren Hülle 5 des kissenförmigen Konzentratörs 1 strebt immer einen möglichst geringen Überdruck zur Umgebung und damit ein maximales Volumen an. Zur Einstellung der Krümmung der Reflektormembran 4 können daher das Verhältnis der Länge der Spannelemente 7' und Breite der Reflektormembran 4 zwischen zwei nebeneinander befindlichen Längsträgern 9 variiert werden. Derartige zusätzliche Spannelemente 7' können die Distanz zwischen zwei Längsträgern 9 über Zug verkleinern und somit die Krümmung des entsprechenden Abschnitts A der Reflektormembran 4 erhöhen, oder den Abstand zwischen zwei Längsträgern 9 über Druck erhöhen und somit die Krümmung des entsprechenden Abschnitts A erniedrigen.

Bei der Ausführungsform gemäß Fig. 1a sind die Absorber 2 an den Längsträgern 8 an der transparenten Membran 3 über entsprechende Befestigungselemente 10 befestigt. Theoretisch können die Absorber 2 auch direkt in den Längsträgern 8 an der transparenten Membran 3 integriert sein (nicht dargestellt).

Bei der Variante gemäß Fig. 1b sind die Absorber 2 über ein entsprechendes Befestigungselement 10, beispielsweise eine Stange, im Schnittpunkt der kreuzweise angeordneten Spannelemente 7 platziert.

Die Ausführungsform gemäß Fig. 1c unterscheidet sich von jener gemäß Fig. 1b dadurch, dass die Absorber 2 über entsprechende Befestigungselemente 10 direkt mit der transparenten Membran 3 verbunden sind. Anstelle der Verwendung eigener Befestigungselemente 10 können die Absorber 2 auch an die Innenseite der transparenten Membran 3 geklebt werden.

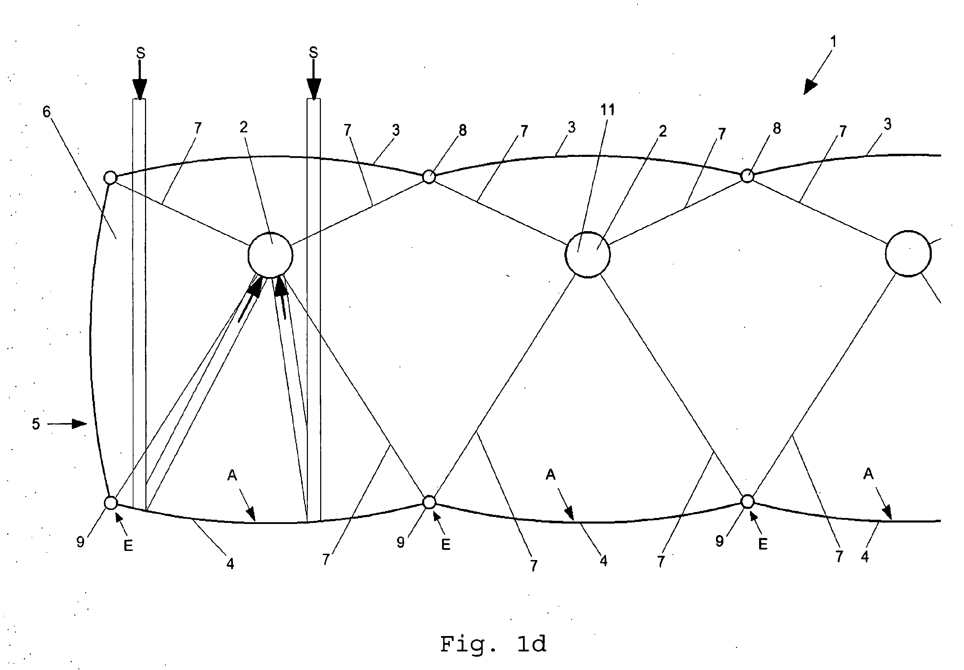

Bei der Variante gemäß Fig. 1d werden die Spannelemente 7 unter Zwischenschaltung der Absorber 2 zwischen der transparenten Membran 3 und der Reflektormembran 4 angeordnet. Somit sind die Absorber 2 quasi freischwebend im Raum 6 angeordnet. Natürlich kann auch ein entsprechender Befestigungskörper 11 zwischen den Spannelementen 7 platziert werden, an welchen Befestigungskörper 11 die Absorber 2 montiert werden. Bei den Varianten gemäß Fig. 1b, 1c und 1d können die Längsträger 8 an der transparenten Membran gegenüber der Variante gemäß Fig. 1a schwächer ausgebildet werden; da die Längsträger 8 nicht die Absorber 2 tragen müssen.

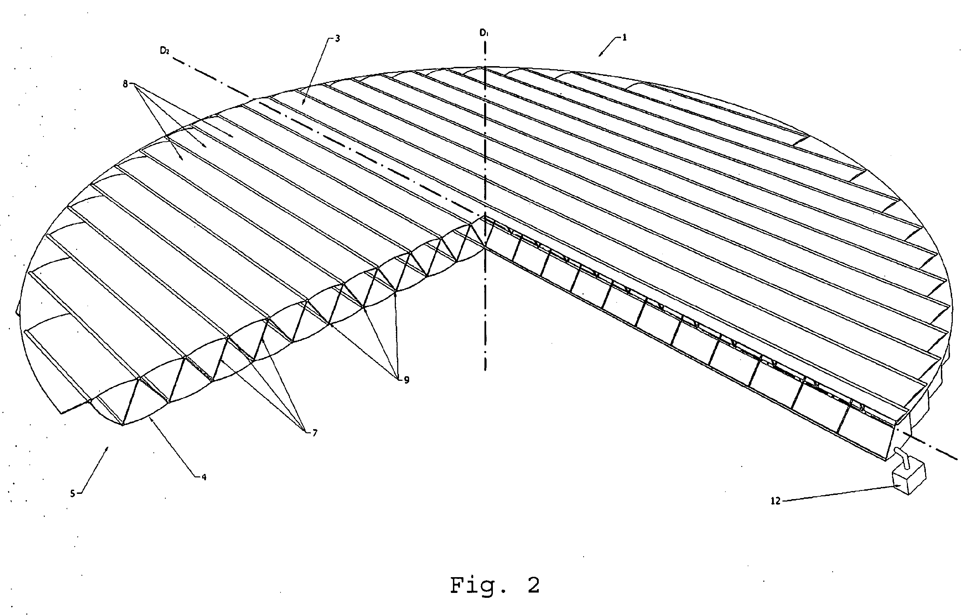

Fig. 2 zeigt eine teilweise geschnittene perspektivische Ansicht eines runden kissenförmigen Konzentrators 1, bei dem die Spannelemente 7 zwischen der transparenten Membran 3 und der Reflektormembran 4 in einer Längsrichtung der Hülle 5 fachwerkartig abgewinkelt angeordnet sind. Ein derartiger kissenförmiger Konzentrator 1 kann eine räumliche Ausdehnung von wenigen Metern bis hin zu mehreren Kilometern aufweisen. Dementsprechend kann die transparente Membran 3 und die Reflektormembran 4 zur Bildung der Hülle 5 selbstverständlich auch mehrteilig ausgebildet sein. An der transparenten Membran 3 sind mehrere parallel zueinander angeordnete Längsträger 8 und an der Reflektormembran 4 ebenfalls parallel verlaufende Längsträger 9 angeordnet. Um eine Nachführung des kissenförmigen Konzentrators 1 in Richtung der Strahlungsquelle, beispielsweise Sonne, zu ermöglichen, ist es von Vorteil, wenn die Hülle 5 um eine senkrecht zu ihrer Haupterstreckungsebene verlaufende Drehachse D₁ drehbar gelagert ist. Ebenso kann es von Vorteil sein, wenn die Hülle um eine in der Haupterstreckungsebene der Hülle 5 verlaufende Drehachse D₂ drehbar gelagert ist. Die Bewegung des kissenförmigen Konzentrators 1 kann durch entsprechende Antriebe (nicht dargestellt) oder die Verlagerung in der Hülle 5 angeordneter Auftriebsgase erzielt werden. Eine zur Aufrechterhaltung des Überdrucks in der Hülle 5 verwendete Pumpe 12 ist schematisch dargestellt. In dieser Ausführungsform ist als Absorber 2 vorzugsweise ein langgestreckter Linienabsorber vorgesehen, dem jeweils ein gewölbter Abschnitt A der Reflektormembran 4 mit einer in Längserstreckungsrichtung des Absorbers 2 im Wesentlichen konstanten Wölbung zugeordnet. Der Absorber 2 kann an dem mit der transparenten Membran 3 verbundenen Längsträger 8 befestigt sein, wie in Fig. 1a näher erläutert wurde. Eine weitere besonders günstige Methode die Krümmung zu erniedrigen, ist die Veränderung der Vorspannung des gesamten kissenförmigen Konzentrators 1 entlang einer oder beider ihrer Haupterstreckungsachsen. Dies kann bei einer schwimmenden Plattform beispielsweise durch eine verstärkte Anwendung von Maßnahmen erfolgen, die radial nach außen gerichtete Kräfte bewirken.

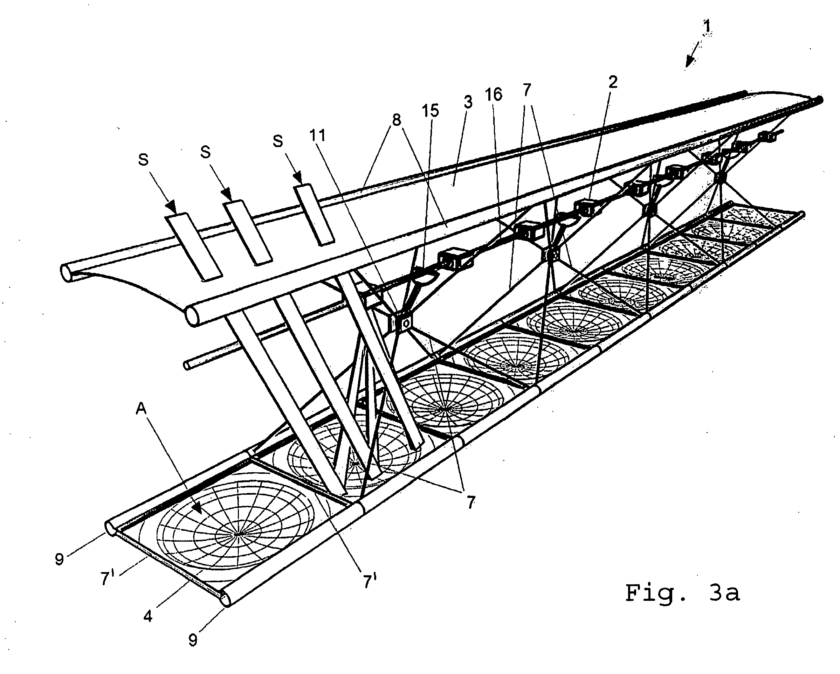

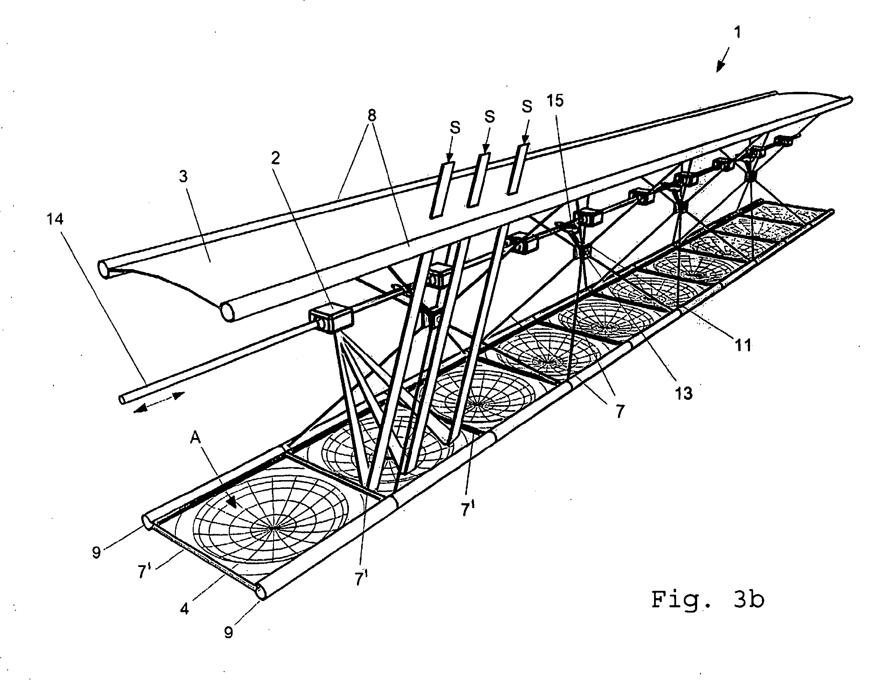

Die Fig. 3a und 3b zeigen eine weitere Ausführungform eines kissenförmigen Konzentrators 1, wobei in der Reflektormembran 4 durch entsprechende Anordnung der Spannelemente 7 konkav gewölbte Abschnitte A gebildet sind, die die Form einer Kugelkalotte oder eines Drehparaboloids aufweisen. Dadurch werden die einfallenden Strahlen, insbesondere Sonnenstrahlen S, im Wesentlichen auf einen kleinen Punkt reflektiert und gebündelt, weshalb punktförmige Absorber 2 verwendet werden können. Zusätzlich zu den beispielsweise durch Seile oder Stangen gebildeten Spannelementen 7 zwischen der transparenten Membran 3 und der Reflektormembran 4 können auch weitere Spannelemente 7' zur Festlegung der konkav gewölbten Abschnitte A in der Reflektormembran 4 angeordnet sein. Während flache, zweidimensionale, unelastische Membranen durch Druckunterschied nur eindimensional knitterfrei gekrümmt werden können, ist es für derartige zweidimensionale Krümmungen der Reflektormembran 4 und zur optimalen Annäherung der gewünschten Form des Abschnitts A günstig, wenn die Reflektormembran 4 aus Segmenten zusammengesetzt ist. Dies ist beispielsweise bei Fußbällen (Fünfecke und Sechsecke) oder Wasserbällen (ähnliche Auflösung der Kugelform in die Ebene wie bei einer Erbkarte) bekannt. Durch derartige in zwei Dimensionen konkav gewölbte Abschnitte A in der Reflektormembran 4 wird eine besonders hohe Konzentration der Strahlung, insbesondere Sonnenstrahlung S, in den Absorbern 2 erzielt. Sofern der kissenförmige Konzentrator 1 nicht der Strahlungsquelle, insbesondere Sonne, nachbewegt wird, kann durch eine Veränderung der Position des Absorbers 2 auf Veränderungen der Richtung der Strahlenquelle, insbesondere Sonne, Einfluss genommen werden.

Die Fig. 3a und 3b zeigen eine entsprechende Ausführungsform eines kissenförmigen Konzentrators 1 bei unterschiedlicher Sonneneinstrahlung und entsprechend angepasster Lage der Absorber 2. Zu diesem Zweck sind die Absorber 2 mit einer Antriebsvorrichtung 13 gekoppelt, so dass deren Lage verändert werden kann. Zu diesem Zweck sind die Absorber 2 mit einem Kupplungselement 14, insbesondere einer Kupplungsstange, verbunden und über eine Verbindungsstange 15 mit einer im Befestigungskörper 11 angeordneten Antriebsvorrichtung 13 drehbar verbunden. Auf diese Weise kann eine optimale Ausnutzung der Strahlung, insbesondere Sonnenstrahlung S, auch bei Veränderungen der Richtung der Sonnenstrahlung S erzielt werden. Die Verstellung der Absorber 2 erfolgt dabei vorzugsweise automatisch durch die Anordnung entsprechender Detektoren, welche den Ort der Strahlungsquelle, insbesondere der Sonne, erfassen und über eine entsprechende Steuerung, Signale an die Antriebsvorrichtungen 13 senden (nicht dargestellt).

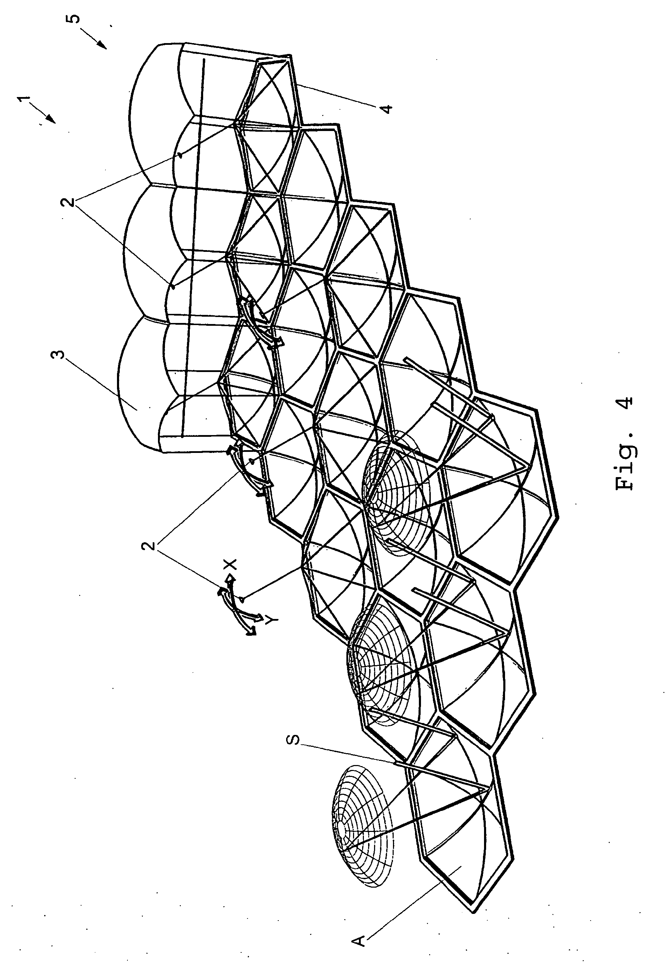

Fig. 4 zeigt eine weitere Ausführungsform eines Teils eines kissenförmigen Konzentrators 1, wobei die Reflektormembran 4 durch entsprechende Anordnung der Spannelemente 7 in konkav gewölbte wabenförmige Abschnitte A unterteilt wurde. Bei der Verwendung des kissenförmigen Konzentrators 1 zur Bündelung von Sonnenstrahlung S würden die an den konkav gewölbten Abschnitten A der Reflektormembran 4 reflektierten Sonnenstrahlen entlang einer kugelkalottenförmigen oder paraboloidförmigen Fläche eine Bewegung vollziehen. Zur entsprechenden Nachführung der Absorber 2 müssten diese entlang zweier Achsen verschiebbar bzw. verschwenkbar angeordnet sein, wie anhand der Pfeile X, Y dargestellt wird. Bei einer zweiachsigen Nachführung des Absorbers 2 kann der kissenförmige Konzentrator 1 ortsfest beispielsweise auf einem Binnengewässer oder einem statischen Luftkissen dank Auftriebsgas schwebend fix mit dem Boden verspannt oder als Gebäudedach bzw. Schattenspender zum Beispiel über Parkplätzen nahe den Endverbrauchern montiert werden ohne gedreht oder geneigt werden zu müssen. Bei einem ortsfest verankertem kissenförmigen Konzentrator 1 ist es auch vorteilhaft, die Verankerung desselben zur Vorspannung der Hülle 5 zu nützen, so dass die Krümmung kosteneffizient reduziert bzw. abgeflacht werden kann.

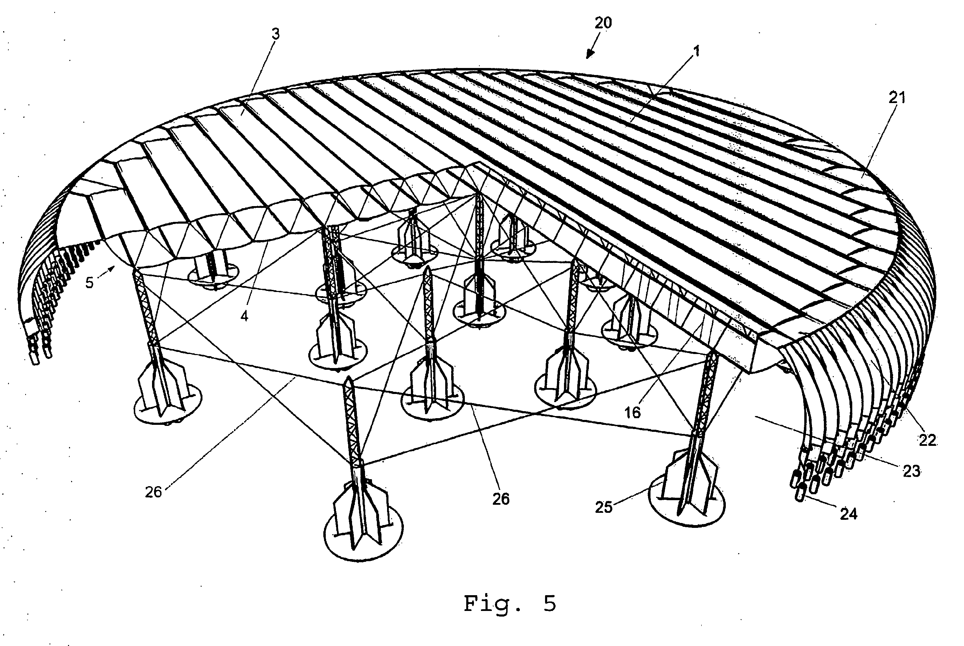

Fig. 5 zeigt schließlich eine Anwendung eines kissenförmigen Konzentrators 1 in Kreisform, welcher auf einer schwimmenden Plattform 20 angeordnet ist. Auf diese Weise kann beispielsweise am Meer ein Solarkraftwerk errichtet werden. Insbesondere bei großen Ausdehnungen des kissenförmigen Konzentrators 1 ist es von Vorteil, wenn die Hülle 5 durch zumindest eine insbesondere transparente Folie 16, in zumindest zwei Kammern unterteilt ist. Diese Folie 16 ist ebenfalls als Spannelement 7 ausgebildet und bewirkt die entsprechenden Einschnürungen in der Reflektormembran 4 und somit die gewünschte Wölbung. Die schwimmende Plattform 20 weist ein flächiges Deckelement 21 und ein damit verbundenes Abdichtelement 22 auf, das im Betrieb in dichtendem Kontakt mit einer Flüssigkeitsoberfläche steht und gemeinsam mit dem Deckelement 21 und der Flüssigkeitsoberfläche bzw. einer Bodenfläche des Deckelements 21 einen geschlossenen Hohlraum 23 einschließt. Im Hohlraum 23 kann mit einer Drucklufterzeugungsvorrichtung (nicht dargestellt) ein die Plattform 20 tragender Überdruck hergestellt werden. Über entsprechende Schwimmkörper 24 kann das vorzugsweise durch eine Folie gebildete Abdichtelement 22 in der gewünschten Orientierung gehalten werden. Treibanker 25 können der Plattform 20 eine entsprechende Stabilität verleihen. Zusätzlich können entsprechende Verstrebungen 26 oder Verspannungen für entsprechende Stabilität sorgen.

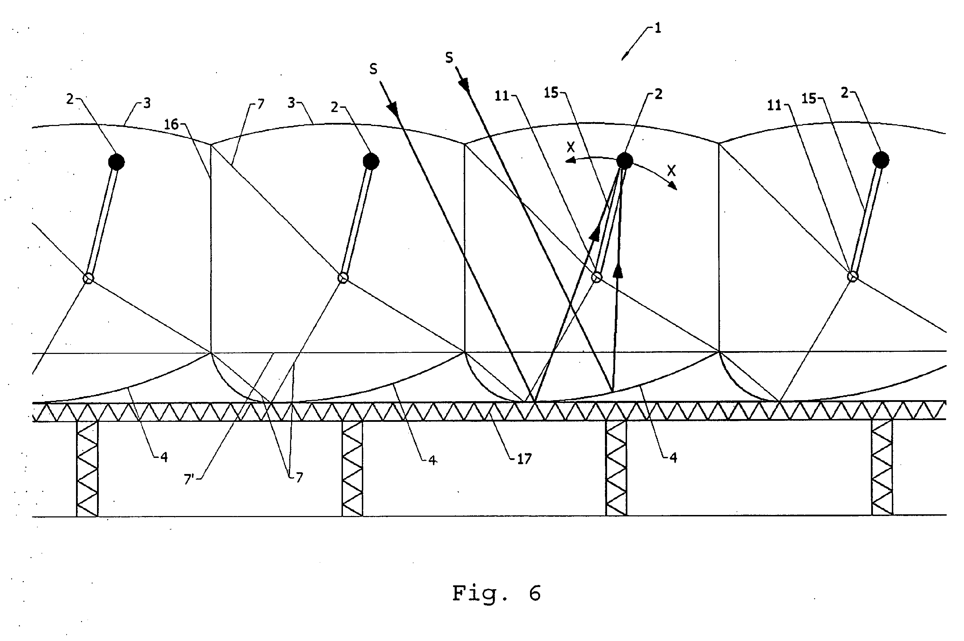

Fig. 6 zeigt ein weiteres Ausführungsbeispiel eines ortsfesten kissenförmigen Konzentrators 1 mit eindimensional gekrümmter Reflektormembran 4 im Querschnitt. Bei einer derartigen ortsfesten Anordnung des kissenförmigen Konzentrators 1 ist dieser beispielsweise auf einem entsprechenden Gestellt 17 bzw. auf einem Gewässer schwimmend angeordnet. Im Falle einer eindimensionalen Krümmung der Reflektormembran 4 werden die Sonnenstrahlen S in einem im Wesentlichen linienförmigen Absorber 2 gebündelt. Zur Anpassung des Absorbers 2 an die Strahlungsquelle, insbesondere den Sonnenstand, kann der Absorber 2 in einer Achse bewegt werden, wie anhand der Pfeile X veranschaulicht. Bei derartigen nachgeführten Absorbern 2 ist es günstig, wenn der Abstand zwischen der transparenten Membran 3 und der Reflektormembran 4 größer ist als der Krümmungsradius der Reflektormembran 4, da dann die Absorber 2 windgeschützt innerhalb des kissenförmigen Konzentrators 1 positioniert werden können und die Spannelemente 7 auch als Auflagepunkte für die Nachführung der Absorber 2 genutzt werden können.

Eine besonders günstige Ausführungsform eines kissenförmigen Konzentrators 1 sieht die Neigung jeder zweiten Reihe zur Strahlungsquelle, insbesondere Sonne, vor, indem das Verhältnis der Längen der Spannelemente 7' und Breiten der Reflektormembran 4 zwischen zwei nebeneinander befindlichen Längsträgern 9 variiert wird. Dadurch können höhere Konzentrationsfaktoren bei der Nachführung der Absorber 2 erreicht werden. Eine Erhöhung der Konzentration wird auch durch die dargestellte asymmetrische Krümmung der Reflektormembran 4 erzielt.

Eine derartige Anwendung eines ortsfesten kissenförmigen Konzentrators 1 kann beispielsweise zur kostengünstigen Verschattung von Parkplätzen in unmittelbarer Nähe zu Endverbrauchern verwendet werden.

## Patentansprüche

1. Kissenförmiger Konzentrator (1) zur Bündelung elektromagnetischer Strahlung, insbesondere Sonnenstrahlung (S), in einem Absorber (2), mit einer im Betrieb der einfallenden Strahlung zugewandten transparenten Membran (3) und einer Reflektormembran (4), die die auftreffende Strahlung in Richtung des Absorbers (2) reflektiert, **dadurch gekennzeichnet, dass** die transparente Membran (3) und die Reflektormembran (4) eine äußere Hülle (5) für einen mit einem Gas unter Überdruck befüllten Raum (6) bilden, wobei zwischen der transparenten Membran (3) und der Reflektormembran (4) Spannelemente (7) angeordnet sind, die Einschnürungen (E) an der Reflektormembran (4) erzeugen, die konkav gewölbte Abschnitte (A) der Reflektormembran (4) trennen.

2. Kissenförmiger Konzentrator (1) nach Anspruch 1, **dadurch gekennzeichnet, dass** als Spannelement (7) ein Längselement, insbesondere ein quer zu seiner Längserstreckungsrichtung formveränderliches Längselement, vorzugsweise ein Seil, oder ein starres Längselement, vorzugsweise eine Stange, vorgesehen ist, das unter Zugbeanspruchung gespannt ist.

3. Kissenförmiger Konzentrator (1) nach Anspruch 1 oder 2, **dadurch gekennzeichnet, dass** die transparente Membran (3) bzw. die Reflektormembran (4) auf zumindest einem starren Längsträger (8, 9) abgestützt ist.

4. Kissenförmiger Konzentrator (1) nach einem der Ansprüche 1 bis 3, **dadurch gekennzeichnet, dass** jeweils zwei oder mehr Spannelemente (7) an einem gemeinsamen Befestigungsbereich insbesondere des starren Längsträgers (8, 9) befestigt sind" wobei die Spannelemente (7) vorzugsweise in eine Längsrichtung der Hülle (5) fachwerkartig abgewinkelt angeordnet sind.

5. Kissenförmiger Konzentrator (1) nach einem der Ansprüche 1 bis 4, **dadurch gekennzeichnet, dass** die Hülle (5) insbesondere durch lokale Veränderung einer auf die Hülle (5) wirkenden Auftriebskraft um eine in der Haupterstreckungsebene der Hülle (5) verlaufende Drehachse (D₂) drehbar gelagert ist.

6. Kissenförmiger Konzentrator (1) nach einem der Ansprüche 1 bis 5, **dadurch gekennzeichnet, dass** die Spannelemente (7) insbesondere sternförmig zwischen einem zentral im Inneren der Hülle (5) angeordneten Befestigungskörper (11) und der transparenten Membran (3) bzw. der Reflektormembran (4) gespannt sind.

7. Kissenförmiger Konzentrator (1) nach einem der Ansprüche 1 bis 6, **dadurch gekennzeichnet, dass** ein konkav gewölbter Abschnitt (A) der Reflektormembran (4) durch ein Schnittmuster der Reflektormembran (4) bzw. durch den Überdruck des Gases im Inneren der Hülle (5) derart geformt ist, dass die von der Reflektormembran (4) reflektierte Strahlung in einer im Wesentlichen linienförmigen oder einer im Wesentlichen punktförmigen Fläche am Absorber (2) gebündelt wird.

8. Kissenförmiger Konzentrator (1) nach einem der Ansprüche 1 bis 7, **dadurch gekennzeichnet, dass** als Absorber (2) zumindest ein langgestreckter Linienabsorber vorgesehen ist, dem jeweils ein konkav gewölbter Abschnitt (A) der Reflektormembran (4) mit einer in Längserstreckungsrichtung des Linienabsorbers im Wesentlichen konstanten Wölbung zugeordnet ist, wobei der Linienabsorber vorzugsweise an einem mit der transparenten Membran (3) verbundenen Längsträger (8) befestigt ist.

9. Kissenförmiger Konzentrator (1) nach einem der Ansprüche 1 bis 8, **dadurch gekennzeichnet, dass** als Absorber (2) in Abstand zueinander angeordnete kleinflächige Punktabsorber vorgesehen sind, wobei jedem Punktabsorber ein in der Art eines Rotationskörpers, insbesondere einer Kugelkalotte oder eines Paraboloids, konkav gewölbte Abschnitt (A) der Reflektormembran (4) zugeordnet ist.

10. Kissenförmiger Konzentrator (1) nach einem der Ansprüche 1 bis 9, **dadurch gekennzeichnet, dass** der Absorber (2) mit einer Antriebsvorrichtung (13), insbesondere einem selbsthemmenden Untersetzungsgetriebe, einem Schrittmotor, oder einem hydraulisch oder pneumatisch betätigbaren Linearantrieb, verschieblich bzw. um zumindest eine Drehachse verschwenkbar gelagert ist, wobei der Absorber (2) mit der Antriebsvorrichtung (13) vorzugsweise in einachsig entlang einer insbesondere kreisbogenförmig gekrümmten Bahn oder zweiachsig entsprechend insbesondere einer Rotationskörperoberfläche verschiebbar bzw. verschwenkbar ist.

11. Kissenförmiger Konzentrator (1) nach einem der Ansprüche 1 bis 10, **dadurch gekennzeichnet, dass** der bzw. die Absorber (2) über ein Verbindungselement (14), insbesondere eine verschwenkbare Verbindungsstange, an zumindest einem ortsfesten Befestigungskörper gelagert sind.

12. Kissenförmiger Konzentrator (1) nach einem der Ansprüche 9 bis 11, **dadurch gekennzeichnet, dass** die Punktabsorber über eine gemeinsame Kupplung, insbesondere eine Kupplungsstange (15) oder ein Seil, in ihrer Relativposition unbeweglich zueinander angeordnet sind, wobei die Punktabsorber mit der Antriebsvorrichtung (13) synchron verschieblich bzw. verschwenkbar sind.

13. Kissenförmiger Konzentrator (1) nach einem der Ansprüche 1 bis 12, **dadurch gekennzeichnet, dass** die Hülle (5) durch zumindest eine insbesondere transparente und vorzugsweise als Spannelement (7) ausgebildete Folie (16) in zumindest zwei Kammern unterteilt ist, wobei die Hülle (5) vorzugsweise durch im Wesentlichen parallel zueinander angeordnete Folien (16) in langgestreckte Kammern unterteilt ist, welche vorzugsweise jeweils durch quer zu ihrer Längserstreckung verlaufende Folien (16) unterteilt sind.

14. Schwimmende Plattform (20) mit einem flächigen Deckelement (21) und einem mit dem Deckelement (21) verbundenen Abdichtelement (22), das im Betrieb in dichtendem Kontakt mit einer Flüssigkeitsoberfläche steht und gemeinsam mit dem Deckelement (21) und der Flüssigkeitsoberfläche bzw. einer Bodenfläche einen geschlossenen Hohlraum (23) einschließt, in dem mit einer Drucklufterzeugungsvorrichtung ein die Plattform (20) tragender Überdruck herstellbar ist, vorzugsweise zudem mit Komponenten für einen Betrieb der Plattform als Solaranlage, insbesondere ein Wechselrichter bzw. eine Dampfturbine, **dadurch gekennzeichnet, dass** das Deckelement (21) zumindest einen kissenförmigen Konzentrator (1) nach einem der Ansprüche 1 bis 13 aufweist.

15. Schwimmende Plattform (20) nach Anspruch 14, **dadurch gekennzeichnet, dass** das Deckelement (21) bzw. das Abdichtelement (22) mit einem Schwimmkörper (24), insbesondere einem langgestreckten Schwimmkörper, der im Betrieb tief in die Flüssigkeit ragt, einem im Betrieb auf der Flüssigkeitsoberfläche treibenden Schwimmkörper, oder einem vollständig in die Flüssigkeit eingetauchten Schwimmkörper, verbunden ist, wobei vorzugsweise eine Mehrzahl von Schwimmkörpern untereinander insbesondere mittels Verstrebungen oder Verspannungen verbunden sind.

## Claims

1. A cushion-shaped concentrator (1) for concentrating electromagnetic radiation, in particular solar radiation (S), in an absorber (2), comprising a transparent membrane (3) that faces the incoming radiation during operation and a reflector membrane (4) which reflects the incident radiation in the direction of the absorber (2), **characterized in that** the transparent membrane (3) and the reflector membrane (4) form an outer casing (5) for a chamber (6) filled with a gas at overpressure, wherein tension elements (7) are arranged between the transparent membrane (3) and the reflector membrane (4), said tension elements (7) producing constrictions (E) on the reflector membrane (4) that separate concavely curved sections (A) of the reflector membrane (4).

2. The cushion-shaped concentrator (1) according to claim 1, **characterized in that** the tension element (7) is a longitudinal element, in particular a longitudinal element deformable transversely to its longitudinal extension, preferably a rope, or a rigid longitudinal element, preferably a rod, which is tensioned under tensile load.

3. The cushion-shaped concentrator (1) according to claims 1 or 2, **characterized in that** the transparent membrane (3) or the reflector membrane (4), respectively, is supported on at least one rigid longitudinal support (8, 9).

4. The cushion-shaped concentrator (1) according to any of claims 1 to 3, **characterized in that** two or more respective tension elements (7) are fastened at a joint fastening region in particular of the rigid longitudinal support (8, 9), wherein the tension elements (7) are arranged to be angled in the kind of a framework preferably in a longitudinal direction of the casing (5).

5. The cushion-shaped concentrator (1) according to any of claims 1 to 4, **characterized in that** the casing (5) is mounted to be rotated about a rotational axis (D₂) extending in the main extension plane of the casing (5) in particular by a local modification of a buoyancy force acting on the casing (5).

6. The cushion-shaped concentrator (1) according to any of claims 1 to 5, **characterized in that** the tension elements (7) are tensioned in particular radially between a fastening body (11) that is arranged centrally in the interior of the casing (5) and the transparent membrane (3) or the reflector membrane (4), respectively.

7. The cushion-shaped concentrator (1) according to any of claims 1 to 6, **characterized in that** a concavely curved section (A) of the reflector membrane (4) is formed by a pattern of the reflector membrane (4) or by the overpressure of the gas in the interior of the casing (5), respectively, such that the radiation reflected by the reflector membrane (4) is concentrated in a substantially linear or a substantially point-shaped area at the absorber (2).

8. The cushion-shaped concentrator (1) according to any of claims 1 to 7, **characterized in that** at least one elongate line absorber is provided as the absorber (2) to which a respective concavely curved section (A) of the reflector membrane (4) with a curvature that is substantially constant in the direction of longitudinal extension of the line absorber is assigned, wherein the line absorber is preferably fastened at a longitudinal support (8) connected with the transparent membrane (3).

9. The cushion-shaped concentrator (1) according to any of claims 1 to 8, **characterized in that** small-area point absorbers arranged at a distance to each other are provided as absorbers (2), wherein a section (A) of the reflector membrane (4) which is concavely curved in the kind of a rotation body, in particular a spherical cap or a paraboloid, is assigned to each point absorber.

10. The cushion-shaped concentrator (1) according to any of claims 1 to 9, **characterized in that** the absorber (2) is mounted to be displaced or swiveled about at least one axis of rotation by means of a drive device (13), in particular a self-locking reduction gear unit, a step motor, or a hydraulically or pneumatically operable linear drive, wherein the absorber (2) is adapted to be displaced or swiveled, respectively, by the drive means (13) preferably uniaxially along a path that is curved in particular in the shape of a circular arc, or biaxially in correspondence with a rotation body surface in particular.

11. The cushion-shaped concentrator (1) according to any of claims 1 to 10, **characterized in that** the absorber(s) is/are mounted via a connecting element (14), in particular a swivelable connecting rod, at at least one stationary fastening body.

12. The cushion-shaped concentrator (1) according to any of claims 9 to 11, **characterized in that** the point absorbers are, via a joint coupling, in particular a coupling rod (15) or a rope, arranged to be immovable with respect to each other in their relative position, wherein the point absorbers are adapted to be displaced or swiveled synchronously with the drive device (13).

13. The cushion-shaped concentrator (1) according to any of claims 1 to 12, **characterized in that** the casing (5) is divided into at least two chambers by at least one in particular transparent film (16)that is preferably designed as a tension element (7), wherein the casing (5) is divided into elongate chambers preferably by films (16) that are arranged substantially parallel to each other, which elongate chambers are preferably each divided by films (16) extending transversely to their longitudinal extension.

14. A floating platform (20) comprising a flat cover element (21) and a sealing element (22) connected with the cover element (21), which makes a sealing contact with a liquid surface during operation and encloses a closed cavity (23) together with the cover element (21) and the liquid surface or a bottom surface, in which cavity (23) an overpressure which supports the platform (20) can be produced by a compressed-air production apparatus, preferably additionally comprising components for an operation of the platform as a solar plant, in particular an inverter and/or a steam turbine, **characterized in that** the cover element (21) comprises at least one cushion-shaped concentrator (1) according to any of claims 1 to 13.

15. The floating platform (20) according to claim 14, **characterized in that** the cover element (21) or the sealing element (22), respectively, is connected with a floating body (24), in particular an elongate floating body projecting deeply into the liquid during operation, a floating body floating on the liquid surface during operation, or a floating body completely immersed in the liquid, wherein preferably a plurality of floating bodies are connected with each other particularly by means of struts or braces.

## Revendications

1. Concentrateur en forme de coussinet (1) pour la focalisation d'un rayonnement électromagnétique, en particulier un rayonnement solaire (S), dans un absorbeur (2), avec une membrane transparente (3) orientée pendant le fonctionnement du rayonnement incident et une membrane réflectrice (4), qui réfléchit le rayonnement apparaissant en direction de l'absorbeur (2), **caractérisé en ce que** la membrane transparente (3) et la membrane réflectrice (4) forment une enveloppe externe (5) pour une chambre (6) remplie de gaz en surpression, des éléments tendeurs (7) étant disposés entre la membrane transparente (3) et la membrane réflectrice (4), qui produisent des restrictions (E) sur la membrane réflectrice (4), qui séparent les sections (A) incurvées de manière concave de la membrane réflectrice (4).

2. Concentrateur en forme de coussinet (1) selon la revendication 1, **caractérisé en ce que**, en tant qu'élément tendeur (7), un élément longitudinal, en particulier un élément longitudinal de forme variable transversalement par rapport à la direction de son extension longitudinale, de préférence un câble ou un élément longitudinal rigide, de préférence une tige, est prévu, qui est tendu sous l'effet d'une sollicitation de traction.

3. Concentrateur en forme de coussinet (1) selon la revendication 1 ou 2, **caractérisé en ce que** la membrane transparente (3) ou la membrane réflectrice (4) est appuyée sur au moins un support longitudinal rigide (8, 9).

4. Concentrateur en forme de coussinet (1) selon l'une des revendications 1 à 3, **caractérisé en ce que**, respectivement, deux ou plusieurs éléments tendeurs (7) sont fixés sur une zone de fixation commune, en particulier du support longitudinal rigide (8, 9), les éléments tendeurs (7) étant de préférence disposés dans une direction longitudinale de l'enveloppe (5) en étant pliés à la manière d'un treillis.

5. Concentrateur en forme de coussinet (1) selon l'une des revendications 1 à 4, **caractérisé en ce que** l'enveloppe (5) est logée de manière rotative, en particulier grâce à la modification locale d'une force d'entraînement agissant sur l'enveloppe (5), autour d'un axe de rotation (D₂) traversant le plan d'extension principal de l'enveloppe (5).

6. Concentrateur en forme de coussinet (1) selon l'une des revendications 1 à 5, **caractérisé en ce que** les éléments tendeurs (7) sont tendus en particulier en forme d'étoile entre un corps de fixation (11) disposé de manière centrale à l'intérieur de l'enveloppe (5) et la membrane transparente (3) ou la membrane réflectrice (4).

7. Concentrateur en forme de coussinet (1) selon l'une des revendications 1 à 6, **caractérisé en ce qu'**une section (A), incurvée de manière concave, de la membrane réflectrice (4) est formée à l'aide d'une matrice de découpe de la membrane réflectrice (4) ou par la surpression du gaz à l'intérieur de l'enveloppe (5), de sorte que le rayonnement réfléchi par la membrane réflectrice (4) est focalisé sur une surface essentiellement de forme linéaire ou une surface essentiellement ponctuelle sur l'absorbeur (2).

8. Concentrateur en forme de coussinet (1) selon l'une des revendications 1 à 7, **caractérisé en ce que**, en tant qu'absorbeur (2), au moins un absorbeur linéaire à extension longitudinale est prévu, auquel est affectée une section (A) incurvée de manière concave de la membrane réflectrice (4) avec une courbure essentiellement constante dans la direction de l'extension longitudinale de l'absorbeur linéaire, l'absorbeur linéaire étant de préférence fixé à un support longitudinal (8) relié à la membrane transparente (3).

9. Concentrateur en forme de coussinet (1) selon l'une des revendications 1 à 8, **caractérisé en ce que**, en tant qu'absorbeur (2), des absorbeurs ponctuels de petite surface, disposés à une certaine distance les uns des autres, sont prévus, une section (A), incurvée de manière concave, à la manière d'un corps rotatif, en particulier d'une calotte sphérique ou d'un paraboloïde, de la membrane réflectrice (4) correspondant à chaque absorbeur ponctuel.

10. Concentrateur en forme de coussinet (1) selon l'une des revendications 1 à 9, **caractérisé en ce que** l'absorbeur (2) est mobile avec un dispositif d'entraînement (13), en particulier un démultiplicateur à blocage automatique, un moteur pas à pas ou un entraînement linéaire actionnable de manière hydraulique ou pneumatique, ou logé de manière pivotante autour d'au moins un axe de rotation, l'absorbeur (2) avec un dispositif d'entraînement (13) étant mobile ou pivotant, de préférence sur un axe le long d'une trajectoire en particulier incurvée en forme d'arc de cercle ou sur deux axes correspondant en particulier à une surface d'un corps en rotation.

11. Concentrateur en forme de coussinet (1) selon l'une des revendications 1 à 10, **caractérisé en ce que** le ou les absorbeurs (2) sont logés à via un élément de liaison (14), en particulier une tige de liaison pivotante, sur au moins un corps de fixation fixe.

12. Concentrateur en forme de coussinet (1) selon l'une des revendications 9 à 11, **caractérisé en ce que** les absorbeurs ponctuels sont disposés via un dispositif d'accouplement commun, en particulier une tige d'accouplement (15) ou un câble, de manière immobile en ce qui concerne leur position relative les uns par rapport aux autres, les absorbeurs ponctuels étant mobiles ou pivotants de manière synchrone avec le dispositif d'entraînement (13).

13. Concentrateur en forme de coussinet (1) selon l'une des revendications 1 à 12, **caractérisé en ce que** l'enveloppe (5) est divisée en au moins deux chambres par au moins un film (16) en particulier transparent et conçu de préférence comme un élément tendeur (7), l'enveloppe (5) étant divisée de préférence en chambres oblongues par des films (16) disposés de préférence parallèlement entre eux, qui sont divisées de préférence chacun par des films (16) transversaux par rapport à leur extension longitudinale.

14. Plateforme flottante (20) avec un élément de recouvrement (21) de grande étendue et un élément d'étanchéité (22) relié à l'élément de recouvrement (21), qui est, en fonctionnement, en contact étanche avec une surface de liquide et inclut, de manière commune avec l'élément de recouvrement (21) et la surface de liquide ou une surface de sol, un espace creux (23) fermé, dans lequel, peut être produit avec un dispositif de production d'air comprimé, une surpression supportant la plateforme (20), de préférence, en outre, avec des composants pour le fonctionnement de la plateforme en tant qu'installation photovoltaïque, en particulier un onduleur ou une turbine à vapeur, **caractérisé en ce que** l'élément de recouvrement (21) présente au moins un concentrateur en forme de coussinet (1) selon l'une des revendications 1 à 13.

15. Plateforme flottante (20) selon la revendication 14, **caractérisé en ce que** l'élément de recouvrement (21) ou l'élément d'étanchéité (22) est relié avec un corps flottant (24), en particulier un corps flottant allongé, qui dépasse profondément dans le liquide pendant le fonctionnement, un corps flottant dérivant à la surface du liquide pendant le fonctionnement ou un corps flottant plongé entièrement dans le liquide, une pluralité de corps flottants étant de préférence reliés entre eux, en particulier au moyen de renforts ou de haubans.
